# EUROPEAN PATENT SPECIFICATION

(11) **EP 3 441 845 B1**
(45) Date of publication and mention of the grant of the patent: **27.10.2021**
(21) Application number: 18176255.0
(22) Date of filing: 06.06.2018
(51) Int. Cl.: G06F 1/16, G02F 1/133

(54) **DISPLAY PANEL AND ELECTRONIC DEVICE HAVING THE SAME**
ANZEIGETAFEL UND ELEKTRONISCHE VORRICHTUNG DAMIT
PANNEAU D'AFFICHAGE ET DISPOSITIF ÉLECTRONIQUE EN ÉTANT ÉQUIPÉ

(30) Priority: 11.08.2017 KR 20170102611; 15.03.2018 US 201815922745
(43) Date of publication of application: 13.02.2019
(73) Proprietor: Samsung Display Co., Ltd., Gyeonggi-do (KR)
(72) Inventor: Choi, Wonwoo, Hwaseong-si, Gyeonggi-do (KR); Sung, Wooyong, Seoul (KR); Yoon, Seungho, Hwaseong-si, Gyeonggi-do (KR); Cho, Wonje, Osan-si, Gyeonggi-do (KR)
(74) Representative: Gulde & Partner

(56) References cited:
- KR-A- 20150 025 388
- US-A1- 2007 090 457
- US-A1- 2014 027 791
- US-A1- 2016 202 515
- US-A1- 2017 148 856

## Description

### Technical Field

Aspects of embodiments of the present disclosure relate to a display panel and an electronic device having the same.

### Background Art

An electronic device is activated by an electric signal. The electronic device may include a display device configured to display an image, or a touch sensor configured to sense an external input. In a display device, an organic light emitting display device has lower power consumption, high brightness, and high response speed.

The organic light emitting display device includes an organic light emitting device. The organic light emitting device is vulnerable to moisture or oxygen, thereby being easily damaged. Accordingly, in the organic light emitting display device, if the moisture or oxygen introduced from the outside is more stably blocked, it may result in the reliability of the organic light emitting display device being improved and the life span being improved. US2016202515 relates to a liquid crystal display device and a method of manufacturing the same. US2014027791A1 relates to a display apparatus including a liquid crystal layer interposed between display substrates. US2007090457A1 relates to a TFT substrate wherein lifting of thin films formed on a plastic insulation substrate is reduced and a method of fabricating the same. US2017148856A1 relates to organic light-emitting displays and methods of manufacturing the same.

### SUMMARY

The present application is defined in independent claim 1. Further aspects of the invention are set out in the dependent claims.

### BRIEF DESCRIPTION OF THE DRAWINGS

The accompanying drawings are included to provide a further understanding of the inventive concept, and are incorporated in and constitute a part of this specification. The drawings illustrate some exemplary embodiments of the inventive concept and, together with the description, serve to describe principles of the inventive concept. In the drawings:
FIG. 1 is a perspective view illustrating an electronic device according to an embodiment of the inventive concept;
FIG. 2 is an exploded perspective view of the electronic device illustrated in FIG. 1;
FIG. 3 is a block diagram of the electronic device illustrated in FIG. 1;
FIG. 4 is a cross-sectional view taken along the line I-I' of FIG. 2;
FIG. 5 is an enlarged cross-sectional view illustrating a portion of FIG. 4;
FIG. 6 is an enlarged cross-sectional view illustrating a portion of FIG. 5;
FIG. 7 is an enlarged cross-sectional view illustrating a portion of an electronic device according to an embodiment of the inventive concept;
FIG. 8A and FIG. 8B are enlarged cross-sectional views illustrating a portion of an electronic device according to an embodiment of the inventive concept;
FIG. 9 is an enlarged cross-sectional view illustrating a portion of an electronic device according to an embodiment of the inventive concept;
FIG. 10 is a cross-sectional view illustrating a portion of a display panel according to an embodiment of the inventive concept;
FIGS. 11A to 11C are plan views schematically illustrating a portion of configuration of a display panel according to an embodiment of the inventive concept;
FIGS. 12A to 12J are cross-sectional views illustrating a manufacturing method of a display panel according to an embodiment of the inventive concept; and
FIGS. 13A to 13E are cross-sectional views illustrating a manufacturing method of a display panel according to an embodiment of the inventive concept.

### DETAILED DESCRIPTION

Herein, some embodiments of the inventive concept are described in further detail with reference to the accompanying drawings.

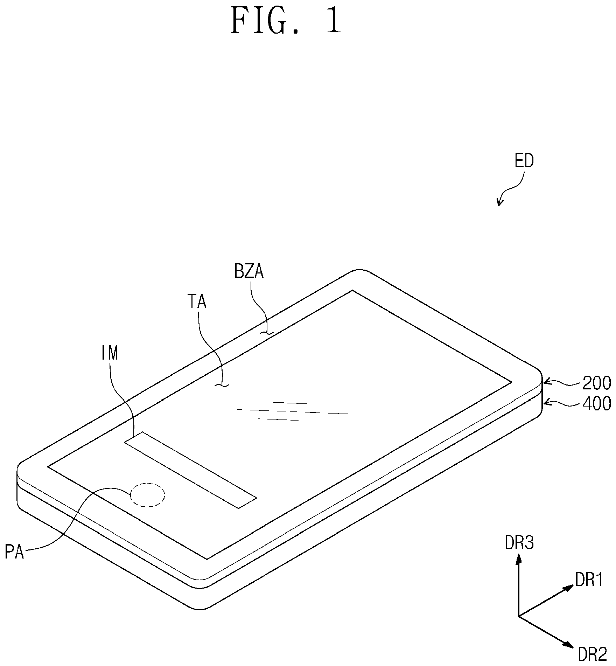

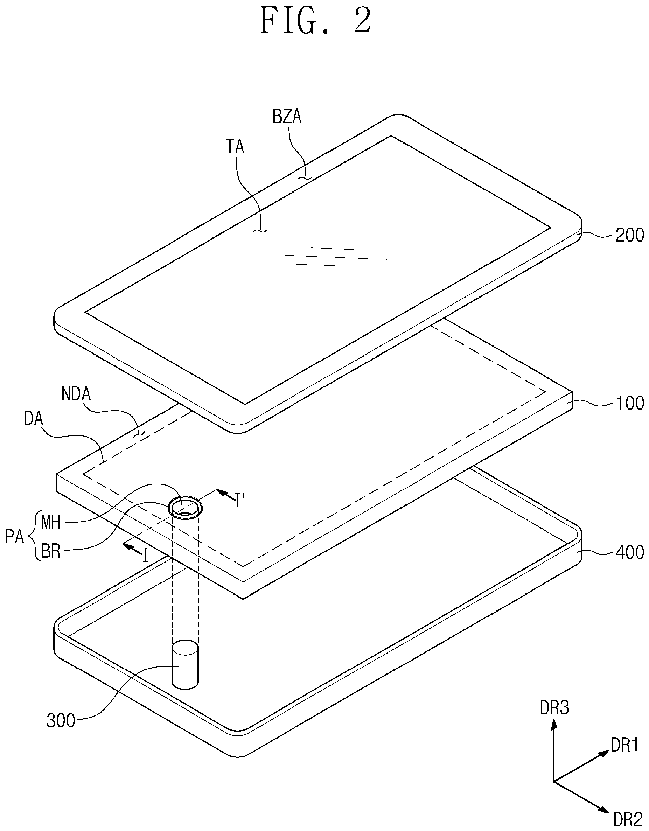

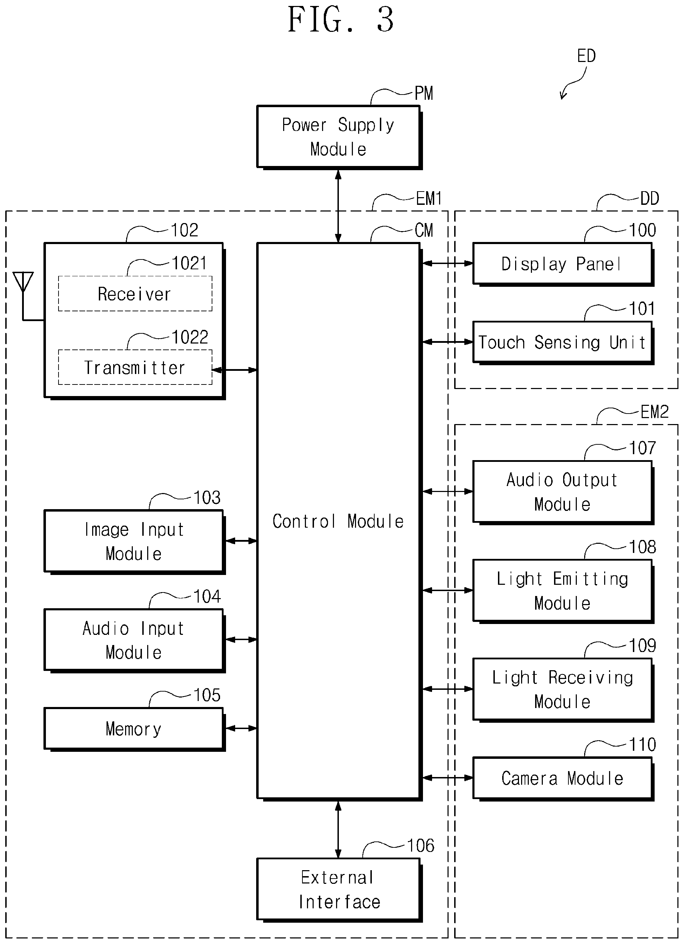

FIG. 1 is a perspective view illustrating an electronic device according to an embodiment of the inventive concept. FIG. 2 is an exploded perspective view of the electronic device illustrated in FIG. 1. FIG. 3 is a block diagram of the electronic device illustrated in FIG. 1. Herein, an electronic device according to an embodiment of the inventive concept will be described with reference to FIGS. 1 to 3.

An electronic device ED may be a device activated by an electronic signal. The electronic device ED may include any of various embodiments. For example, the electronic device ED may include any of a tablet, a notebook, a computer, a smart television, and the like. In an embodiment, the electronic device ED is exemplarily illustrated as a smartphone.

As shown in FIG. 1, the electronic device ED may provide a display surface for displaying an image IM on a front surface thereof. The display surface may be defined to be parallel to a surface defined by a first direction DR1 and a second direction DR2. The display surface includes a display area DA and a bezel area BZA adjacent to the display area DA.

The electronic device ED is configured to display the image IM in the display area DA. In FIG. 1, the display area DA may have a rectangular shape that is parallel to the first direction DR1 and the second direction DR2, respectively. However, this is an exemplary illustration, and the display area DA may have any of various shapes and is not limited to any embodiment.

The bezel area BZA is adjacent to the display area DA. The bezel area BZA may surround the display area DA. However, this is an exemplary illustration, and the bezel area BZA may be disposed adjacent to one or more sides of the display area only, or may be omitted. The electronic device ED according to an embodiment of the inventive concept may include any of various embodiments, and is not limited to any embodiment.

A normal direction of the display surface may correspond to a thickness direction DR3 (a third direction) of the electronic device ED. In this embodiment, the front surface (or the top surface) and the rear surface (or the bottom surfaces) of each member are defined based on a direction in which the image IM is displayed. The front surface and the rear surface are opposed or opposite to each other in the third direction DR3.

However, indicative directions of the first to third directions DR1, DR2, DR3 are a relative concept and may be changed to other directions. Herein, the first to third directions are directions respectively indicated by first to third directions DR1, DR2, DR3 and refer to same reference numerals.

As shown in FIGS. 1 to 3, in an embodiment, the electronic device ED includes a display panel 100, a window member 200, an electronic module 300, and a housing member 400. As shown in FIG. 3, the electronic device ED may further include a display module DD, a first electronic module EM1, a second electronic module EM2, and a power supply module PM. Some of configurations shown in FIG. 3 are omitted in FIG. 2.

The display module DD may include the display panel 100 and a touch sensing unit 101. The display panel 100 is configured to generate the image IM. The display panel 100 may sense a user input applied from the outside. Then, the display panel 100 may further include a touch sensor; however, the touch sensing unit 101 may be omitted.

The touch sensing unit 101 senses a user input applied from the outside. The user input may include any of various forms of external inputs, such as a portion of a user's body part, light, heat, or pressure. The touch sensing unit 101 is not shown in FIG. 2.

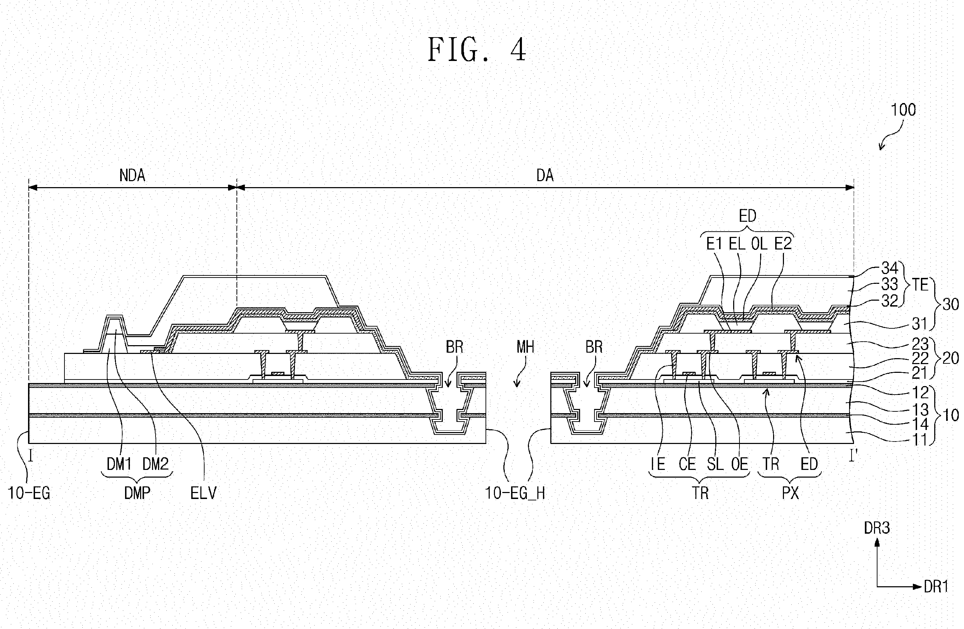

The display panel 100 is divided into the display area DA and a periphery area NDA. The display area DA may be an area in which the image IM is generated, as described above. A plurality of pixels PX (see FIG. 4) generating the image IM may be disposed in the display area DA. Further detailed description thereof will be described later herein.

The periphery area NDA is adjacent to the display area DA. In an embodiment, the periphery area NDA may surround the display area DA. A driving circuit or a driving line for driving the display area DA may be disposed in the periphery area NDA.

In an embodiment, although not illustrated, a portion of the periphery area NDA of the display panel 100 may be curved. Thereby, the portion of the periphery area NDA may be directed to the front surface of the electronic device ED, and the other portion of the periphery area NDA may be directed to the rear surface of the electronic device ED. Alternatively, the periphery area NDA may be omitted in the display panel 100 according to a non claimed embodiment of the inventive concept.

The display panel 100 according to an embodiment of the inventive concept may include a module part PA provided in the display area DA. The module part PA defines a space in which an electronic module 300 is disposed. The module part PA may include a module hole MH and a blocking groove BR.

The module hole MH passes through the display panel 100. In an embodiment, the module hole MH may have a cylindrical shape having a height in the third direction DR3. The electronic module 300 may overlap the module hole MH in a plan view. The module hole MH may accommodate the electronic module 300. In embodiments of the inventive concept, the display panel 100 may realize a thin display device by including the module hole MH.

The blocking groove BR is disposed adjacent to the module hole MH. The blocking groove BR is formed by being recessed from the front surface of the display panel 100. The blocking groove BR has a shape of a closed curve surrounding the module hole MH in a plane. In an embodiment, the blocking groove BR may have a ring shape that surrounds the module hole MH. The module hole MH and the blocking groove BR will be described in further detail later herein.

The window member 200 provides the front surface of the electronic device ED. The window member 200 is disposed on the front surface of the display panel 100 to provide protection to the display panel 100. For example, the window member 200 may include a glass substrate, a sapphire substrate, or a plastic film. The window member 200 may have a multi-layered or single-layered structure. For example, the window member 200 may have a laminate structure of a plurality of plastic films that are bonded by an adhesive, or may have a laminate structure of a glass substrate and a plastic film that are bonded by an adhesive.

The window member 200 may be divided into a transmission area TA and the bezel area BZA. The transmission area TA may be an area corresponding to the display area DA. For example, the transmission area TA overlaps the front surface of the display area DA or at least a portion thereof. The image IM displayed in the display area DA of the display panel 100 may be viewed from the outside through the transmission area TA.

The bezel area BZA defines the shape of the transmission area TA. The bezel area BZA is adjacent to the transmission area TA, and, in an embodiment, may surround the transmission area TA. The bezel area BZA may have a color (e.g., a predetermined color). The bezel area BZA may cover the periphery area NDA of the display panel 100 to prevent or substantially prevent the periphery area NDA from being viewed from the outside. However, this is an exemplary illustration, and in the window member 200 according to an embodiment of the inventive concept, the bezel area BZA may be omitted.

The power supply module PM supplies power for overall operation of the electronic device ED. In an embodiment, the power supply module PM may include a conventional battery module.

The housing member 400 may be coupled to the window member 200. The housing member 400 provides the rear surface of the electronic device ED. The housing member 400 is coupled to the window member 200 to define an inner space, and the display panel 100, the electronic module 300, and each kind of configurations shown in FIG. 3 may be accommodated in the inner space. The housing member 400 may include a material having relatively high rigidity. For example, the housing member 400 may include a plurality of frames and/or plates composed of glass, plastic, and metal. The housing member 400 may provide stable protection to components of the electronic device ED accommodated in the inner space against an external impact.

The electronic module 300 includes any of various functional modules for operating the electronic device ED. In an embodiment, the electronic module 300 may include the first electronic module EM1 and the second electronic module EM2.

The first electronic module EM1 may be directly mounted on a motherboard that is electrically connected to the display module DD, or mounted on a separate substrate to be electrically connected to the motherboard through a connector (not shown).

In an embodiment, the first electronic module EM1 may include a control module CM, a wireless communication module 102, an image input module 103, an audio input module 104, a memory 105, and an external interface 106. However, some of the modules may not be mounted on the motherboard, and may also be connected to the motherboard through a flexible circuit substrate.

The control module CM controls overall operations of the electronic device ED. In an embodiment, the control module CM may be a microprocessor. For example, the control module CM may control other modules, such as the image input module 103 or the audio input module 104, based on a touch signal received from the display module DD.

In an embodiment, the wireless communication module 102 may transmit/receive a wireless signal to/from another terminal through a Bluetooth or Wi-Fi network. For example, the wireless communication module 102 may transmit/receive an audio signal through a conventional communication network. In an embodiment, the wireless communication module 102 includes a transmitter 1022 configured to modulate and transmit a transmission signal, and a receiver 1021 configured to demodulate a received signal.

The image input module 103 processes an image signal and converts the processed image signal to an image data that may be displayed on the display module DD. The audio input module 104 receives an external audio signal via a microphone in a recording mode, voice recognition mode, etc., and converts the received signal to an electrical voice data.

The external interface 106 serves as an interface to be connected with any of an external charger, wired/wireless data ports, card sockets (such as a memory card and a SIM/UIM card), etc.

In an embodiment, the second electronic module EM2 may include an audio output module 107, a light emitting module 108, a light receiving module 109, and a camera module 110. These configurations may either be directly mounted on the motherboard, or mounted on a separate substrate, thereby being electrically connected to the display module DD or electrically connected to the first electronic module EM1 through a connector (not shown), etc.

The audio output module 107 converts an audio data received from the wireless communication module 102 or an audio data stored in the memory 105 and outputs the converted audio data to the outside.

The light emitting module 108 generates and outputs light. The light emitting module 108 may output infrared rays. The light emitting module 108 may include a light emitting diode (LED) device, for example. The light receiving module 109 may sense infrared rays. In an embodiment, the light receiving module 109 may be activated when infrared rays of a predetermined level or greater are sensed. The light receiving module 109 may include a CMOS sensor, for example. After infrared light generated by the light emitting module 108 is output, the infrared light may be reflected by an external object (such as a user's finger or a face), and the reflected infrared light may be incident in the light receiving module 109. The camera module 110 captures an external image.

The electronic module 300 illustrated in FIG. 2 may include any of the configurations of the second electronic module EM2. Here, the rest of configurations of the first electronic module EM1 and the second electronic module EM2 may be disposed in different positions and may not be shown. However, this is an exemplary illustration, and the electronic module 300 may be any one of the modules constituting the first electronic module EM1 and the second electronic module EM2, and is not limited to any embodiment.

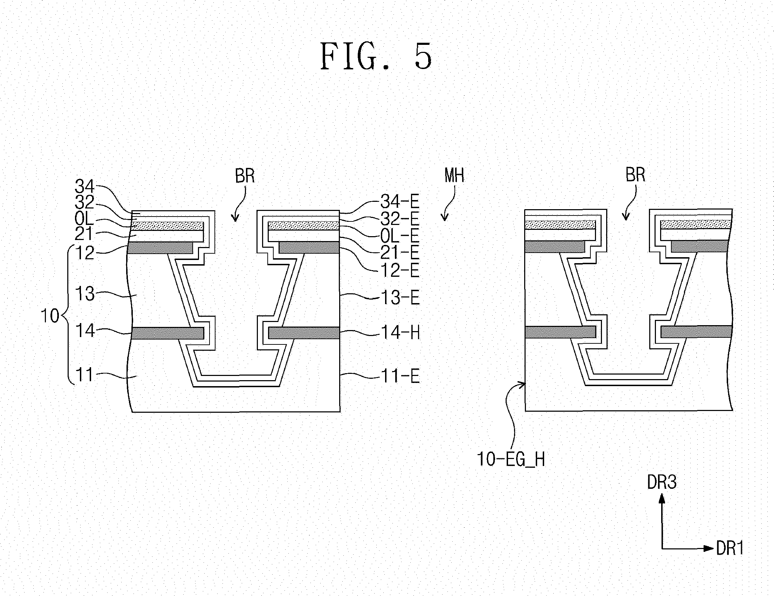

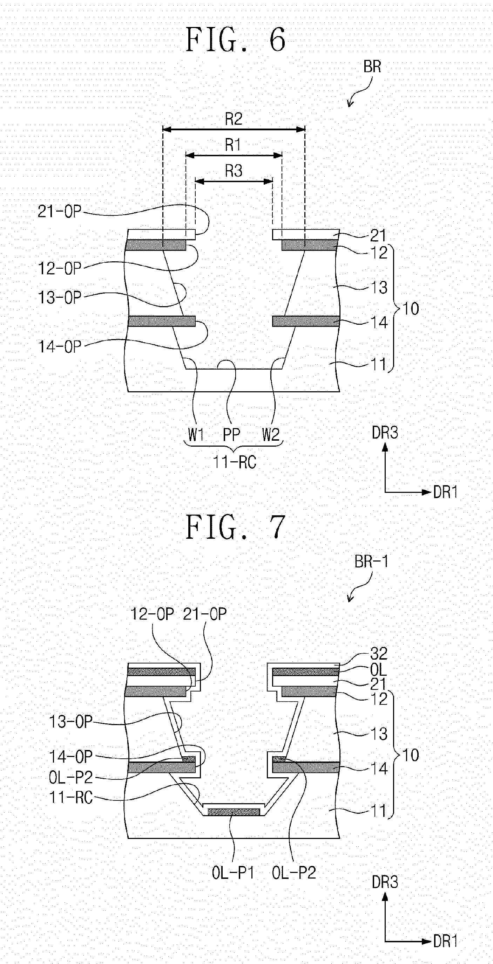

FIG. 4 is a cross-sectional view taken along the line I-I' of FIG. 2. FIG. 5 is an enlarged cross-sectional view illustrating a portion of FIG. 4. FIG. 6 is an enlarged cross-sectional view illustrating a portion of FIG. 5. Herein, a display panel 100 according to an embodiment of the inventive concept will be described with reference to FIGS. 4 to 6.

As shown in FIG. 4, the display panel 100 includes a base substrate 10, a thin film device layer 20, and a display device layer 30. The base substrate 10, the thin film device layer 20, and the display device layer 30 may be laminated along the third direction DR3.

In an embodiment, the base substrate 10 may include a first base layer 11, a first barrier layer 12, a second base layer 13, and a second barrier layer 14.

The first base layer 11 constitutes a bottom layer of the base substrate 10. The rear surface of the first base layer 11 may define the rear surface of the base substrate 10.

The first base layer 11 may be an insulation layer containing an organic material. In an embodiment, the first base layer 11 may include a ductile plastic. For example, the first base layer 11 may include polyimide (PI), polyethylene naphthalate (PEN), polyethylene terephthalate (PET), polyarylate, polycarbonate (PC), polyetherimide (PEI) or polyethersulfone (PES).

The first barrier layer 12 may include an inorganic material. The first barrier layer 12 constitutes the top layer of the base substrate 10. The front surface of the first barrier layer 12 may define the front surface of the base substrate 10.

The first barrier layer 12 may be an insulation layer containing an inorganic material. For example, the first barrier layer 12 may include silicon oxide, silicon nitride, amorphous silicon, or the like.

The second base layer 13 and the second barrier layer 14 may be disposed between the first base layer 11 and the first barrier layer 12. In an embodiment, the second base layer 13 may include the same material as the first base layer 11. In an embodiment, the second barrier layer 14 may include the same material as the first barrier layer 12.

The first base layer 11, the second base layer 13, the first barrier layer 12, and the second barrier layer 14 may be alternately disposed. The first barrier layer 12 and the second barrier layer 14 may be respectively disposed on the second base layer 13 and the first base layer 11. Each of the first barrier layer 12 and the second barrier layer 14 may block external moisture or oxygen that is transmitted through the first base layer 11 and the second base layer 13.

The thin film device layer 20 is disposed on the base substrate 10. The thin film device layer 20 includes a plurality of insulation layers and a thin film transistor TR. Each of the insulation layers may include an inorganic material and/or an organic material. The insulation layers may include first to third insulation layers 21, 22, and 23.

The thin film transistor TR includes a semiconductor pattern SL, a control electrode CE, an input electrode IE, and an output electrode OE. The thin film transistor TR controls charge transfer in the semiconductor pattern SL through the control electrode CE to output an electric signal inputted from the input electrode IE, through the output electrode OE.

The first insulation layer 21 may be disposed between the semiconductor pattern SL and the control electrode CE. In this embodiment, the control electrode CE is illustrated as being disposed on the semiconductor pattern SL. However, this is an exemplary illustration, and the thin film transistor TR according to an embodiment of the inventive concept may include the semiconductor pattern SL being disposed on the control electrode CE, and is not limited to any embodiment.

The second insulation layer 22 may be disposed between the control electrode CE, the input electrode IE, and the output electrode OE. The input electrode IE and the output electrode OE are disposed on the second insulation layer 22. The input electrode IE and the output electrode OE pass through the first insulation layer 21 and the second insulation layer 22 to be connected to the semiconductor pattern SL, respectively. However, this is an exemplary illustration, and the input electrode IE and the output electrode OE may be directly connected to the semiconductor pattern SL.

The third insulation layer 23 is disposed on the second insulation layer 22. The third insulation layer 23 may cover the thin film transistor TR. The third insulation layer 23 electrically insulates the thin film transistor TR and the display device layer 30 from each other.

In an embodiment, the display device layer 30 includes an organic light emitting device ED and a plurality of insulation layers. The insulation layers may include a fourth insulation layer 31 and a sealing member TE.

The fourth insulation layer 31 is disposed on the third insulation layer 23. A plurality of openings may be defined in the fourth insulation layer 31. Each of the openings may be provided with the organic light emitting device ED.

The organic light emitting device ED may include a first electrode E1, a second electrode E2, a light emitting layer EL, and a charge control layer OL. The first electrode E1 is disposed on the thin film device layer 20. The first electrode E1 may pass through the third insulation layer 23 to be electrically connected to the thin film transistor TR. The first electrode E1 may be provided in plurality. At least some of each of a plurality of the first electrodes may be exposed by each of the openings.

The second electrode E2 is disposed on the first electrode E1. The second electrode E2 may have an integral shape overlapping the plurality of first electrodes and the fourth insulation layer 31. When the organic light emitting device is provided in plurality, the second electrode E2 may have the same voltage for each organic light emitting device. Accordingly, a separate patterning process for forming the second electrode E2 may be omitted. However, this is an exemplary illustration, and the second electrode E2 may be provided in plurality to correspond to each of the openings.

The light emitting layer EL is disposed between the first electrode E1 and the second electrode E2. The light emitting layer EL may be provided in plurality to be disposed in each of the openings. The organic light emitting device ED may activate the light emitting layer EL based on a potential difference between the first electrode E1 and the second electrode E2, thereby generating light.

The charge control layer OL is disposed between the first electrode E1 and the second electrode E2. The charge control layer OL is disposed adjacent to the light emitting layer EL. In this embodiment, the charge control layer OL is illustrated as being disposed between the light emitting layer EL and the second electrode E2. However, this is an exemplary illustration, and the charge control layer OL may be disposed between the light emitting layer EL and the first electrode E1, or may be provided in a plurality of layers laminated along the third direction DR3 with the light emitting layer EL therebetween.

In an embodiment, the charge control layer OL may have an integral shape overlapping the front surface of the base substrate 10 without a separate patterning process. The charge control layer OL may be disposed in an area other than the openings formed in the fourth insulation layer 31.

The sealing member TE is disposed on the organic light emitting device ED. The sealing member TE may include an inorganic film and/or an organic film. In an embodiment, the sealing member TE may include a first inorganic film 32, an organic film 33, and a second inorganic film 34.

Each of the first inorganic film 32 and the second inorganic film 34 may include an inorganic material. For example, each of the first inorganic film 32 and the second inorganic film 34 may include at least any of aluminum oxide, silicon oxide, silicon nitride, silicon oxynitride, silicon carbide, titanium oxide, zirconium oxide, and zinc oxide.

The organic film 33 may be disposed between the first inorganic film 32 and the second inorganic film 34. The organic film 33 may include an organic material. For example, the organic film 33 may include at least any of epoxy, polyimide (PI), polyethylene terephthalate (PET), polycarbonate (PC), polyethylene (PE), and polyacrylate.

In an embodiment, the first inorganic film 32 and the second inorganic film 34 may have an integral shape disposed on the front surface of the display panel 100. In an embodiment, each of the first inorganic film 32 and the second inorganic film 34 may partially overlap the organic film 33. Accordingly, the first inorganic film 32 and the second inorganic film 34 may be spaced from each other in the third direction DR3 with the organic film 33 interposed therebetween in some area, and may directly contact with each other in the third direction DR3 in some other area.

The display panel 100 may include a dam part DMP. The dam part DMP may extend along an edge of the display area DA (refer to FIG. 2). In an embodiment, the dam part DMP may surround the display area DA.

In an embodiment, the dam part DMP may include a first dam DM1 and a second dam DM2. The first dam DM1 may include the same material as the third insulation layer 23. The first dam DM1 may be concurrently (e.g., simultaneously) formed with the third insulation layer 23, and may be disposed on the same layer with the third insulation layer 23.

In an embodiment, the second dam DM2 is laminated on the first dam DM1. The second dam DM2 may include the same material as the fourth insulation layer 31. The second dam DM2 may be concurrently (e.g., simultaneously) formed with the fourth insulation layer 31, and may be disposed on the same layer with the fourth insulation layer 31. However, this is an exemplary illustration, and the dam part DMP may have a single layer structure, and is not limited to any embodiment.

The dam part DMP may define an area in which a liquid organic material is spread in a process of forming the organic film 33. In an embodiment, the organic film 33 may be formed by applying the liquid organic material onto the first inorganic film 32 in an inkjet method, and, at this time, the dam part DMP sets a boundary of an area in which the liquid organic material is disposed, and prevents or substantially prevents the liquid organic material from overflowing outside the dam part DMP.

Herein, an area in which the module hole MH and the blocking groove BR are defined will be described in further detail with reference to FIGS. 5 and 6. In FIG. 6, the first inorganic film 32 and the second inorganic film 34 are omitted from the illustration for the convenience of description. The module hole MH passes through the display panel 100 along the third direction DR3. As the module hole MH is defined in the display area DA, the module hole MH passes through not only the base substrate 10, but also a portion of layers constituting the display area DA as well.

The module hole MH passes through the base substrate 10. An inner surface 10-EG_H of the module hole MH may be defined by edges of the plurality of layers. An edge of the first base layer 11-E, an edge of the first barrier layer 12-E, an edge of the second base layer 13-E, and an edge of the second barrier layer 14-E may be defined on the first base layer 11, the first barrier layer 12, the second base layer 13, and the second barrier layer 14, respectively.

Further, the module hole MH passes through at least a portion of the layers constituting the display area DA. For example, the module hole MH may pass through the first insulation film 21, the charge control layer OL, the first inorganic film 32, and the second inorganic film 34. Accordingly, an edge of the first insulation film 21-E, an edge of the charge control layer OL-E, an edge of the first inorganic film 32-E, and an edge of the second inorganic layer 34-E may be defined on the first insulation film 21, the charge control layer OL, the first inorganic film 32, and the second inorganic film 34, respectively.

In an embodiment, the edge of the first base layer 11-E, the edge of the first barrier layer 12-E, the edge of the second base layer 13-E, the edge of the second barrier layer 14-E, the edge of the first insulation film 21-E, the edge of the charge control layer OL-E, the edge of the first inorganic film 32-E, and the edge of the second inorganic film 34-E may be aligned along the third direction DR3. Accordingly, the module hole MH may have a cylindrical shape having a height along the third direction DR3. However, this is an exemplary illustration, and at least some portions of the edges of the respective layers defining the module hole MH may not be aligned with each other, and are not limited to any embodiment.

The blocking groove BR is defined adjacent to the module hole MH. The blocking groove BR may be spaced in the first direction DR1 from the module hole MH. The blocking groove BR is recessed from the front surface of the base substrate 10 in the third direction DR3. Accordingly, the blocking groove BR passes through the front surface of the base substrate 10 but does not pass through the rear surface thereof.

In an embodiment, the blocking groove BR may be formed by eliminating at least some portions of the base substrate 10. For example, the blocking groove BR may be formed by eliminating at least some portions of the first base layer 11, the first barrier layer 12, the second base layer 13, and the second barrier layer 14.

The blocking groove BR according to an embodiment of the inventive concept is defined in the base substrate 10 and includes an inner surface having an undercut shape. The blocking groove BR may include a recessed portion 11-RC and at least one passing-through portion. The recessed portion 11-RC and the at least one passing-through portion form the undercut shape on the inner surface of the blocking groove BR. In an embodiment, the blocking groove BR may include a passing-through portion 12-OP passing through the first barrier layer 12, a passing-through portion 13-OP passing through the second base layer 13, and a passing-through portion 14-OP passing through the second barrier layer 14.

The recessed portion 11-RC is defined in the first base layer 11. The recessed portion 11-RC may be recessed from the front surface of the first base layer 11. The recessed portion 11-RC includes a plane surface PP, a first side surface W1, and a second side surface W2. Although the first side surface W1 and the second side surface W2 are separately illustrated for ease of explanation, the first side surface W1 and the second side surface W2 may be a surface integrally connected to each other.

The plane surface PP may be a recessed surface in the rear surface direction from the front surface of the first base layer 11. The plane surface PP is spaced from the rear surface of the first base layer 11 in the third direction DR3. Each of the first side surface W1 and the second side surface W2 is connected to the plane surface PP. The first side surface W1 and the second side surface W2 may be inclined from the plane surface PP. An angle formed by the first side surface W1 and the second side surface W2 within the recessed portion 11-RC may be equal to or greater than 90 degrees.

The passing-through portion 14-OP of the second barrier layer 14, the passing-through portion 13-OP of the second base layer 13, and the passing-through portion 12-OP of the first barrier layer 12 may be disposed by being laminated in a direction orienting the front surface from the rear surface of the base substrate 10. Here, the passing-through portion 14-OP of the second barrier layer 14 and the recessed portion 11-RC form the undercut shape, and the passing-through portion 12-OP of the first barrier layer 12 and the passing-through portion 13-OP of the second base layer 13 may form the undercut shape.

The second barrier layer 14 protrudes inside the recessed portion 11-RC to cover at least a portion of the recessed portion 11-RC. The width of the passing-through portion 14-OP of the second barrier layer 14 in the first direction DR1 may be less than the width of the recessed portion 11-RC in the first direction DR1. The width of the recessed portion 11-RC in the first direction DR1 may be a length of the recessed portion 11-RC measured closest to the second barrier layer 14.

The first barrier layer 12 protrudes inside the passing-through portion 13-OP of the second base layer 13 to cover at least a portion of the passing-through portion 13-OP of the second base layer 13. A width R1 of the passing-through portion 12-OP of the first barrier layer 12 in the first direction DR1 may be less than a width R2 of the passing-through portion 13-OP of the second base layer 13 in the first direction DR1.

The passing-through portion 13-OP of the second base layer 13 may have different planar areas along the third direction DR3. The width of the passing-through portion 13-OP of the second base layer 13 in the first direction DR1 may be less on a rear surface than on a front surface thereof. In an embodiment, the passing-through portion 13-OP of the second base layer 13 may have a conical shape. However, this is an exemplary illustration, and the passing-through portion 13-OP of the second base layer 13 may have a pyramidal shape or an elliptical conical shape corresponding to a shape of the blocking groove BR on the plane, and is not limited to any embodiment.

The thin film device layer 20 and the display device layer 30 partially overlap the blocking groove BR. The first insulation layer 21 extends adjacent to the blocking groove BR to partially overlap the blocking groove BR. The first insulation layer 21 covers at least a portion of the blocking groove BR. The first insulation layer 21 includes a passing-through portion 21-OP defined in an area corresponding to the blocking groove BR. The passing-through portion 21-OP of the first insulation layer 21 overlaps the blocking groove BR.

In this embodiment, a width R3 of the passing-through portion 21-OP of the first insulation layer 21 in the first direction DR1 may be equal to or less than the width R1 of the passing-through portion 12-OP of the first barrier layer 12 in the first direction DR1. The passing-through portion 21-OP of the first insulation layer 21 may be aligned with the passing-through portion 12-OP of the first barrier layer 12, or may protrude inside the passing-through portion 12-OP of the first barrier layer 12. Accordingly, an undercut shape may be formed between the passing-through portion 21-OP of the first insulation layer 21 and the passing-through portion 12-OP of the first barrier layer 12.

The charge control layer OL may be disposed to extend to an area adjacent to the module hole MH and an area adjacent to the blocking groove BR. The charge control layer OL may not overlap the blocking groove BR. Accordingly, the charge control layer OL may have an edge that is cut off adjacent to the blocking groove BR.

Each of the first inorganic film 32 and the second inorganic film 34 may extend to an area in which the blocking groove BR is disposed. The first inorganic film 32 and the second inorganic film 34 may be disposed along the area adjacent to the blocking groove BR and the inner surface of the blocking groove BR. Accordingly, the inside of the blocking groove BR may be covered by the first inorganic film 32 and the second inorganic film 34.

According to an embodiment of the inventive concept, the charge control layer OL may have an edge that is cut off in an area adjacent to the blocking groove BR, and overlap the blocking groove BR. The edge of the charge control layer OL that is cut off adjacent to the charge control layer OL is covered by the first inorganic film 32 and the second inorganic film 34.

As shown in FIGS. 4 and 5, the base substrate 10, the thin film device layer 20, and the display device layer 30 have cut off edges, respectively, in the area adjacent to the module hole MH. The cut off edges are exposed through the module hole MH. Moisture or oxygen outside the display panel 100 may be introduced to the base substrate 10, the thin film device layer 20, and the display device layer 30 through the exposed edges.

According to an embodiment of the inventive concept, an inflow path of oxygen or moisture being introduced from the module hole MH may be blocked by defining the blocking groove BR adjacent to the module hole MH. As shown in FIG. 5, the charge control layer OL, the edge of which is exposed by the module hole MH, is cut off without extending to the blocking groove BR. The blocking groove BR separates a portion disposed between the module hole MH and the blocking groove BR from a portion disposed outside the blocking groove BR. Accordingly, although external oxygen or moisture is introduced through the module hole MH, the introduced oxygen or moisture is not introduced outside the blocking groove BR, thereby stably preventing or substantially preventing damage to the thin film device layer 20 or the display device layer 30 existing outside the blocking groove BR.

Further, according to an embodiment of the inventive concept, the first inorganic film 32 and the second inorganic film 34 cover between the module hole MH and the blocking groove BR, the inside of the blocking groove BR, and the outside of the blocking groove BR. The charge control layer OL or the first insulation layer 21 that is cut off adjacent to the blocking groove BR is covered by the first inorganic film 32 and the second inorganic film 34. Accordingly, the degree of blocking of introduction of moisture or oxygen may be improved.

FIG. 7 is an enlarged cross-sectional view illustrating a portion of an electronic device according to an embodiment of the inventive concept. In FIG. 7, some configurations are omitted for ease of explanation. Herein, an electronic device according to an embodiment of the inventive concept will be described with reference to FIG. 7. Same reference numerals are given to same or like configurations set forth in FIGS. 1 to 6, and duplicated description thereof will be omitted.

As shown in FIG. 7, at least a portion of the charge control layer OL may be disposed in a blocking groove BR-1. In an embodiment, the charge control layer OL may further include a first portion OL-P1 and a second portion OL-P2 that are disposed in the blocking groove BR-1.

The first portion OL-P1 may be disposed on a recessed portion 11-RC defined in the first base layer 11. The first portion OL-P1 may be disposed in a portion exposed from the second barrier layer 14. The width of the first portion OL-P1 in the first direction DR1 may be equal to or less than the width of the passing-through portion 14-OP of the second barrier layer 14 in the first direction DR1.

The second portion OL-P2 may be disposed on the second barrier layer 14. The second portion OL-P2 may be disposed on a portion of the second barrier layer 14 that is exposed from the second base layer 13. The second portion OL-P2 may be disposed on a portion of the second barrier layer 14 that protrudes more inward of the blocking groove BR-1 than the second base layer 13.

The first portion OL-P1 and the second portion OL-P2 may be cut off or spaced from each other. Further, the first portion OL-P1 and the second portion OL-P2 may be cut off or spaced from the charge control layer OL disposed on the first insulation layer 21.

The first inorganic film 32 covers the inner surface of the blocking groove BR-1. In an embodiment, each of the first portion OL-P1 and the second portion OL-P2 may be covered by the first inorganic film 32. Accordingly, the first portion OL-P1 and the second portion OL-P2 may be prevented or substantially prevented from being separated from the first base layer 11 or the second barrier layer 14.

According to an embodiment of the present disclosure, an inflow path of external contamination may be stably blocked by providing the first blocking groove BR-1 in the base substrate 10. Further, although some portions of the layer remain in the blocking groove BR-1, the portions may be stably fixed through the first inorganic film 32, thereby preventing or substantially preventing device damage caused by floating of the portions. Accordingly, reliability of the electronic device may be improved.

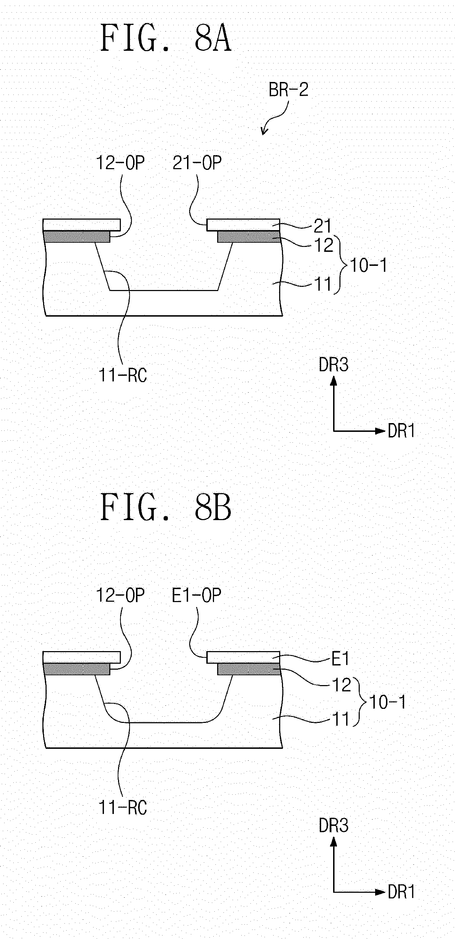

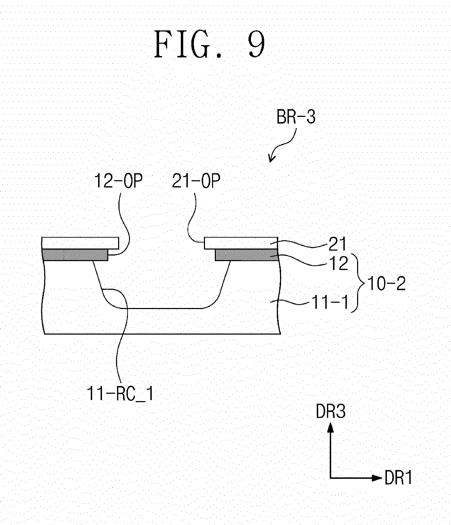

FIG. 8A and FIG. 8B are enlarged cross-sectional views illustrating a portion of an electronic device according to an embodiment of the inventive concept. FIG. 9 is an enlarged cross-sectional view illustrating a portion of an electronic device according to an embodiment of the inventive concept. In FIGS. 8A to 9, blocking grooves BR-2, BR-3 having various shapes are mainly illustrated. Herein, embodiments of the inventive concept will be described with reference to FIGS. 8A to 9. Same reference numerals are given to same configurations set forth in FIGS. 1 to 7, and a duplicated description will be omitted.

As shown in FIGS. 8A and 8B, a base substrate 10-1 may include a first base layer 11 and a first barrier layer 12. A recessed potion 11-RC may be defined in the first base layer 11.

The first barrier layer 12 may be directly disposed on the front surface of the first base layer 11. The first barrier layer 12 may contact the first base layer 11.

A passing-through portion 12-OP may be defined in the first barrier layer 12. In an embodiment, the blocking groove BR-2 may include the recessed portion 11-RC and the passing-through portion 12-OP of the first barrier layer 12. The passing-through portion 12-OP of the first barrier layer 12 may form an undercut shape (e.g., a predetermined undercut shape) with the recessed portion 11-RC. Here, an undercut shape defined by the passing-through portion 12-OP and the recessed portion 11-RC may be defined on the inner surface of the blocking groove BR-2.

As shown in FIG. 8B, the first electrode E1 may be a layer covering the blocking groove BR-2. Here, the first electrode E1 may be disposed further in an area adjacent to the blocking groove BR-2 in addition to the plurality of openings described above. In an embodiment, a passing-through portion E1-OP overlapping the blocking groove BR-2 may be defined in the first electrode E1. The width of the passing-through portion E1-OP of the first electrode E1 in the first direction DR1 may be equal to or less than the width of the passing-through portion 12-OP of the first barrier layer 12 in the first direction.

In an embodiment, although not illustrated, a layer in which a passing-through portion disposed on the first barrier layer 12 to overlap the blocking groove BR-2 is defined may include any of various layers constituting the thin film device layer 20 and the display device layer 30. Further, although not illustrated, the layer in which the passing-through portion overlapping the blocking groove BR-2 is defined may also be provided in plurality.

As shown in FIG. 9, a base substrate 10-2 may include a first base layer 11-1 and the first barrier layer 12. A recessed portion 11-RC_1 may be defined in the first base layer 11-1. The recessed portion 11-RC_1 may have a curved (e.g., a predetermined curved) surface. Accordingly, the blocking groove BR-3 may include a curved surface in the inner surface thereof.

The electronic device according to embodiments of the inventive concept may include blocking grooves having any of various shapes. Further, the electronic device may form a layer for covering the blocking groove through any of various layers. Accordingly, a process may be simplified and a process cost may be reduced by utilizing a portion of existing display panel configurations without adding a separate process. Further detailed description thereof will be described later herein.

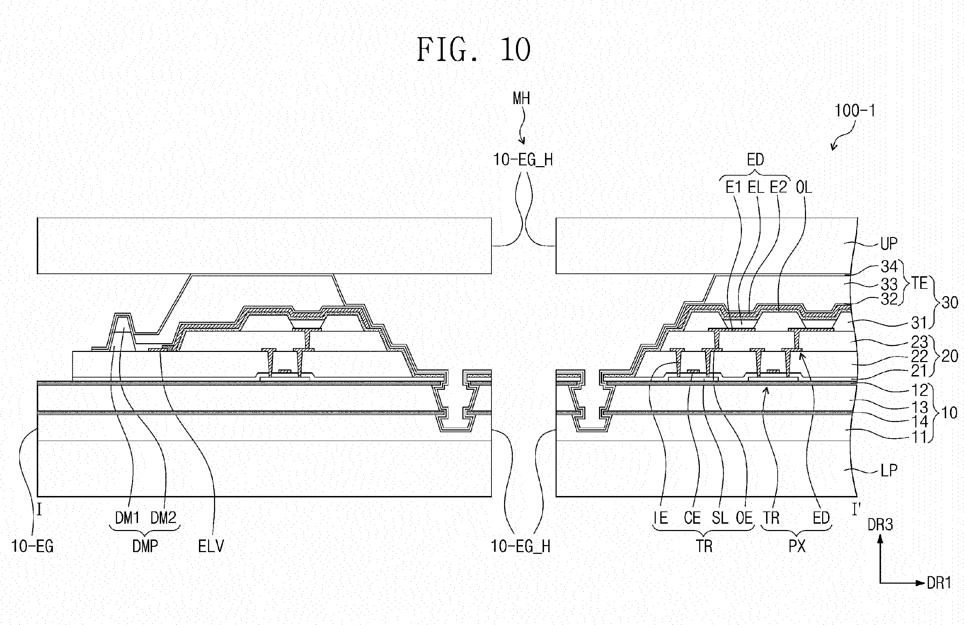

FIG. 10 is a cross-sectional view illustrating a portion of a display panel according to an embodiment of the inventive concept. In FIG. 10, areas corresponding to the areas illustrated in FIG. 4 are illustrated for ease of explanation. A display panel 100-1 illustrated in FIG. 10 may substantially correspond to the display panel 100 illustrated in FIG. 4 other than that the display panel 100-1 further includes an upper film UP and a lower film LP.

Herein, the display panel 100-1 according to an embodiment of the inventive concept will be described with reference to the FIG. 10. Same reference numerals are given to same or like configurations set forth in FIGS. 1 to 9, and duplicated descriptions thereof will be omitted.

As shown in FIG. 10, the display panel 100-1 may include the upper film UP and the lower film LP. The lower film LP is disposed on the rear surface of the base substrate 10. Although not illustrated, an adhesive layer (e.g., a predetermined adhesive layer) may be further disposed between the lower film LP and the upper film UP. The lower film LP is disposed under the base substrate 10 to protect the base substrate 10.

The upper film UP is disposed on the front surface of the base substrate 10. The upper film UP may be disposed on the sealing member TE. In an embodiment, the upper film UP is illustrated as being in contact with the sealing member TE, but separate functional layers may be further added between the sealing member TE and the upper film UP. The upper film UP protects the thin film device layer 20 and the display device layer 30.

In an embodiment, the module hole MH may pass through the upper film UP and the lower film LP. In each of the upper film UP and the lower film LP, passing-through portions corresponding to the module hole MH may be defined. Accordingly, an edge 10-EG_H of the display panel forming the module hole MH may be defined by the lower film LP, the base substrate 10, the thin film device layer 20, the display device layer 30, and the upper film UP.

The display panel 100-1 according to an embodiment of the inventive concept further includes the upper film UP and the lower film LP, such that the base substrate 10, the thin film device layer 20, and the display device layer 30 may be stably protected. Accordingly, the display panel 100-1 according to an embodiment of the inventive concept may have improved durability against an external impact.

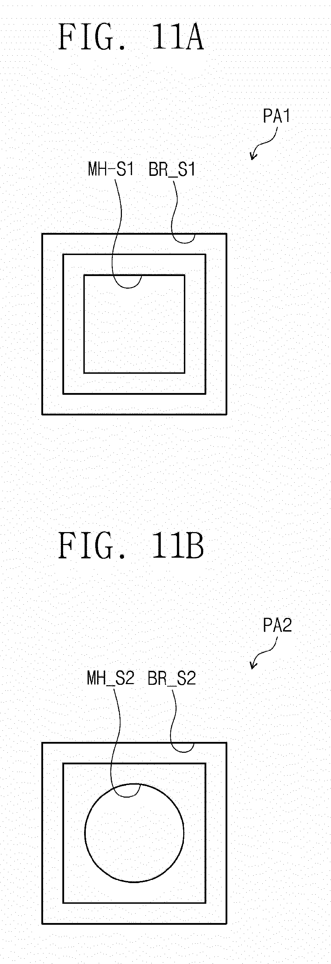

FIGS. 11A to 11C are plan views schematically illustrating a portion of configuration of a display panel according to an embodiment of the inventive concept. In FIGS. 11A to 11C, planar shapes of module parts PA1, PA2, and PA3 are illustrated. The module parts PA1, PA2, and PA3 will be described with reference to FIGS. 11A to 11C, respectively.

As shown in FIG. 11A, the module part PA1 may include a module hole MH-S1 and a blocking groove BR_S1. The module hole MH-S1 may have a polygonal shape when viewed in a plane. In an embodiment, the module hole MH-S1 is illustrated as a quadrangle. In an embodiment, the module hole MH-S1 is implemented as a polygonal columnar shape.

The blocking groove BR_S1 is formed along an edge of the module hole MH-S1. The blocking groove BR_S1 may have a shape corresponding to the module hole MH-S1. Accordingly, in an embodiment, the blocking groove BR_S1 may have a planar shape of a quadrangular ring shape that surrounds the module hole MH-S1.

Alternatively, as shown in FIG. 11B, the module part PA2 may include a module hole MH_S2 and a blocking groove BR_S2 that have different shapes from each other. In an embodiment, the module hole MH_S2 is illustrated as having a circular shape when viewed in a plane. The module hole MH_S2 may have substantially a same shape as the module hole MH illustrated in FIG. 4.

The blocking groove BR_S2 may have a different shape from the module hole MH_S2 when viewed in a plane. In an embodiment, the blocking groove BR_S2 is illustrated as having a quadrangular shape. According to the present disclosure, the blocking groove BR_S2 may have any of various shapes when disposed adjacent to the module hole MH_S2, and is not limited to a shape corresponding to the shape of the module hole MH_S2.

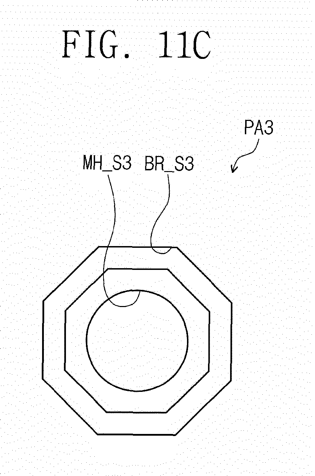

Alternatively, as shown in FIG. 11C, the module part PA3 may include a module hole MH_S3 and a blocking groove BR_S3 that have different shapes from each other. In an embodiment, the blocking groove BR_S3 is illustrated as having an octagonal shape when viewed in a plane. As the blocking groove BR_S3 has a more similar shape to the shape of the module hole MH_S3, the area of a space between the blocking groove BR_S3 and the module hole MH_S3 may gradually decrease. Accordingly, the area occupied by the module part PA3 provided in the display area DA (see FIG. 2) may decrease, and thus the influence to the display area DA may be reduced.

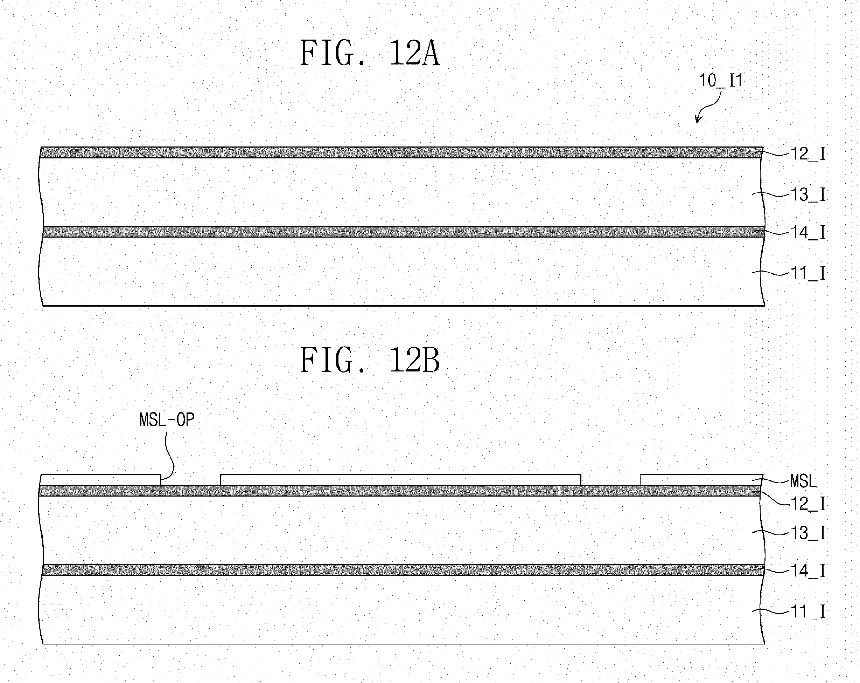

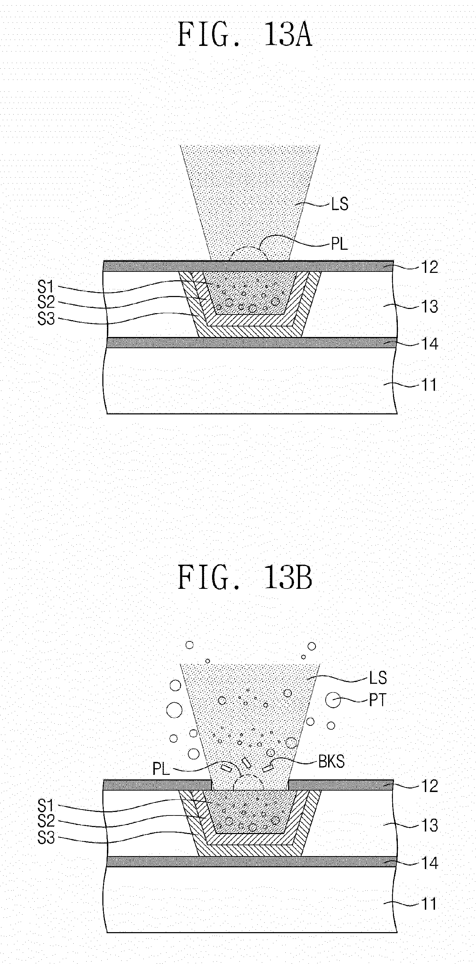

FIGS. 12A to 12J are cross-sectional views illustrating a manufacturing method of a display panel according to an embodiment of the inventive concept. FIGS. 13A to 13E are cross-sectional views illustrating a manufacturing method of a display panel according to an embodiment of the inventive concept. Herein, a method of manufacturing a display device will be described with reference to FIGS. 12A to 13E.

As shown in FIG. 12A, an untreated base substrate 10_I1 is provided. The untreated base substrate 10_I1 includes an untreated first base layer 11_I, an untreated first barrier layer 12_I, an untreated second base layer 13_I, and an untreated second barrier layer 14_I. The untreated first base layer 11_I and the untreated second base layer 13_I may be alternately disposed with the untreated first barrier layer 12_I and the untreated second barrier layer 14_I.

In an embodiment, the untreated first base layer 11_I, the untreated second barrier layer 14_1, the untreated second base layer 13_I, and the untreated first barrier layer 12_I are sequentially laminated toward the upper direction. The untreated first base layer 11_I may define the lowest layer, and the untreated first barrier layer 12_I may define the uppermost layer.

Then, as shown in FIG. 12B, a cover layer MSL may be disposed on the untreated first barrier layer 12_I. The cover layer MSL covers the untreated first barrier layer 12_I.

The cover layer MSL may be formed by using at least one of the thin film device layer 20 (see FIG. 4) and the display device layer 30 (see FIG. 4) that are described above. For example, the cover layer MSL may be formed with at least one of the first to fourth insulation layers 21, 22, 23, 41 (see FIG. 4) and the electrodes CE, IE, OE, E1.

A passing-through portion MSL-OP exposing at least a portion of the untreated first barrier layer 12_I is formed in the cover layer MSL. The passing-through portion MSL-OP of the cover layer may be concurrently (e.g., simultaneously) formed in a formation process of the first to fourth insulation layers 21, 22, 23, 31 (see FIG. 4) and the electrodes CE, IE, OE, E1. Accordingly, the cover layer MSL may use an existing process line without adding a separate process, thereby reducing a process time and reducing a process cost.

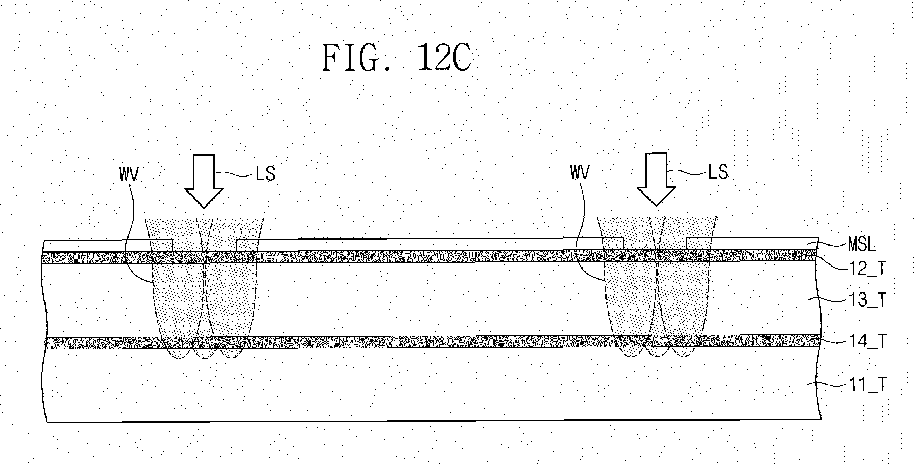

Then, as shown in FIG. 12C, light LS is provided on the cover layer MSL. The light LS may be light provided in an etching process. As shown in FIG. 12C, the light LS may be provided in a radial shape WV. Accordingly, respective layers may be etched in a shape having a greater width towards the upper side thereof.

The untreated first base layer 11_I, the untreated second barrier layer 14_I, the untreated second base layer 13_I, and the untreated first barrier layer 12_I may be converted into a heat-treated first base layer 11_T, a heat-treated second barrier layer 14_T, a heat-treated second base layer 13_T, and a heat-treated first barrier layer 12_T that are heat-treated by the light LS, respectively. Further detailed description with respect to the layers being heat-treated will be described with reference to FIGS. 13A to 13E.

Referring to FIG. 13A, the light LS may be selected as light of wavelength having lower absorption rate for the first barrier layer 12 and higher absorption rate for the second base layer 13. In this embodiment, the light LS may be a UV laser. Most of the light LS may transmit the first barrier layer 12, and the first barrier layer 12 may not be largely affected by the light LS. The light LS may be provided in a laser form.

The light having transmitted the first barrier layer 12 arrives on the second base layer 13 disposed on the rear surface of the first barrier layer 12. The second base layer 13 is designed to have greater absorption rate for the light LS than the first barrier layer 12. In this embodiment, the light LS may be a UV laser. Accordingly, the light LS may arrive on the second base layer 13 to be absorbed in the second base layer 13. Here, a plasma PL may be generated in an area of the first barrier layer 12 on which the light is irradiated.

The second base layer 13 absorbing the light LS may be photo-reacted. The second base layer 13 may be divided into three parts based on reaction degree. A first part S1 may be a part in which the light is absorbed the most during the same period. The first part S1 may be in a state of being possibly evaporated into fine particles by a photoreaction.

A second part S2 may be a part in which less light is absorbed than in the first part S1. The second part S2 may be in a molten state by the photoreaction. A third part S3 may be a part in which less light is absorbed than in the second part S2. The third part S3 may be in a heated state by the photoreaction.

That is, as the light LS is substantially absorbed, the second base layer 13 may be heated, then changed into the molten state, and then changed into the state of being possibly evaporated. The second base layer 13 may be optically transformed in the order of the third part S3, the second part S2, and the first part S1 in each area where the light LS is irradiated.

Then, as shown in FIG. 13B, as an evaporation state continues in the first part S1 or the area of the first part S1 increases, the first part S1 may break through the first barrier layer 12 to be discharged to the outside. Particles PT of the second base layer 13 in the evaporation state are discharged to the outside while breaking through the first barrier layer 12 by evaporation pressure. As a result, fragments BKS broken from the first barrier layer 12 may be generated.

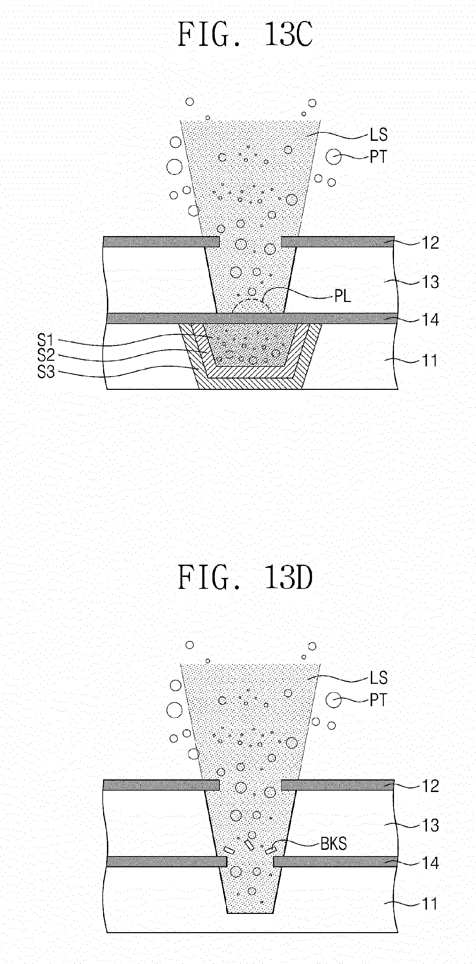

Then, as shown in FIG. 13C, when the second base layer 13 is perforated by continuous irradiation of the light LS, the second barrier layer 14 is exposed. The second barrier layer 14 may be designed to have lower absorption rate for the light LS, and the first base layer 11 may be designed to have higher absorption rate for the light LS. Most of the light LS is transmitted through the second barrier layer 14 to arrive at the first base layer 11. As described above, the first base layer 11 in which the light LS is irradiated absorbs the light LS, and is transformed into the first part S1, the second part S2, and the third part S3, and a portion of the first base layer 11 may be removed while the second barrier layer 14 is broken by the evaporation pressure.

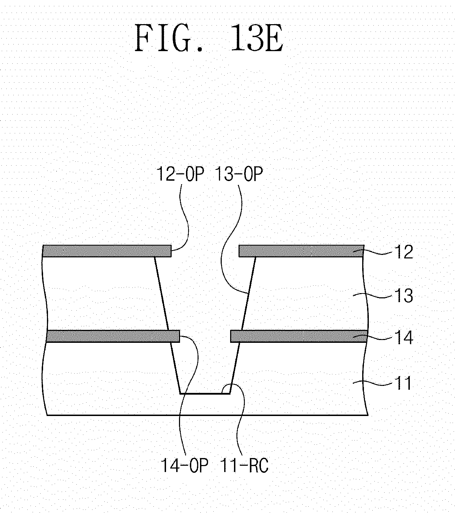

Accordingly, as shown in FIGS. 13D and 13E, the recessed portion 11-RC is formed in the first base layer 11, and the passing-through portion 12-OP of the first barrier layer 12, the passing-through portion 13-OP of the second base layer 13, and the passing-through portion 14-OP of the second barrier layer 14 may be formed.

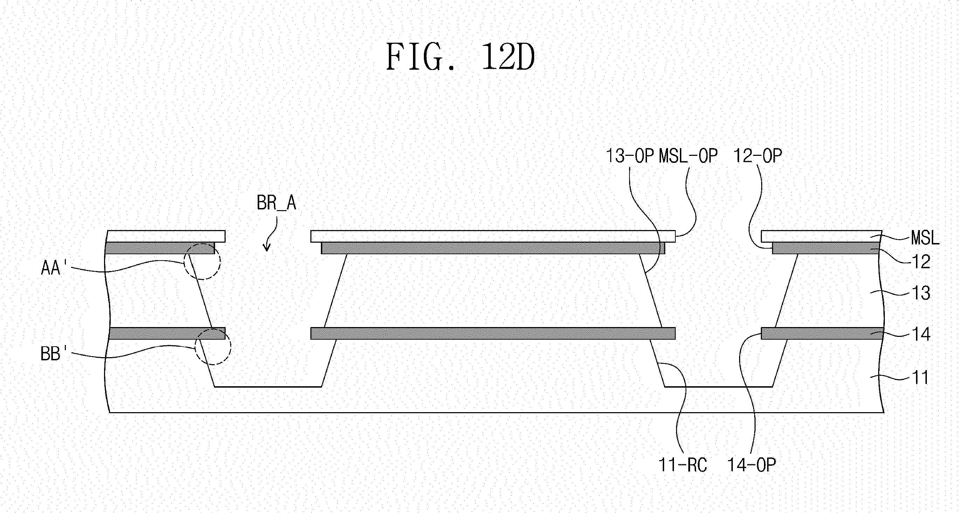

Referring to FIG. 12D again, the blocking groove BR_A may include the recessed portion 11-RC, the passing-through portion 12-OP of the first barrier layer 12, the passing-through portion 14-OP of the second barrier layer 14, and the passing-through portion 13-OP of the second base layer 13.

Due to difference in the absorption rate for the light LS among the layers, the inner surface of the blocking groove BR_A may have an undercut shape in a cross-sectional view. In an AA' region, the second base layer 13 may be undercut with respect to the first barrier layer 12. Accordingly, the first barrier layer 12 may protrude inwardly of the passing-through portion 13-OP of the second base layer 13. Further, in a BB' region, the first base layer 11 may be undercut with respect to the second barrier layer 14. Accordingly, the second barrier layer 14 may protrude inwardly of the recessed portion 11-RC of the first base layer 11.

The cover layer MSL is disposed on the first barrier layer 12, and may prevent or substantially prevent a problem that the undercut shape of the AA' region is irregularly formed due to breakage of the first barrier layer 12 in the etching process. As described above, the blocking groove BR_A according to an embodiment of the inventive concept is formed by evaporation based on absorption of the light LS and breakage of barrier layers. Since the passing-through portion 12-OP of the first barrier layer 12 is formed by breakage of the first barrier layer 12 disposed on the uppermost layer, it may not be easy to stably control the shape of the passing-through portion 12-OP of the first barrier layer 12. Thus, since the passing-through portion 12-OP of the first barrier layer 12 may be formed to have the width equal to or greater than the passing-through portion 13-OP of the second base layer 13, a problem that the undercut shape is not formed in the AA' region may occur.

The method of manufacturing the display panel according to an embodiment of the inventive concept further includes the cover layer MSL to cover the front surface of the first barrier layer 12. Accordingly, the problem that a crack of the first barrier layer 12 is spread or transmitted may be prevented or substantially prevented.

By forming the passing-through portion MSL-OP in a space in which the blocking groove BR_A is to be formed in the cover layer MSL, the size of the blocking groove BR_A may be stably designed and the undercut shape may be stably formed.

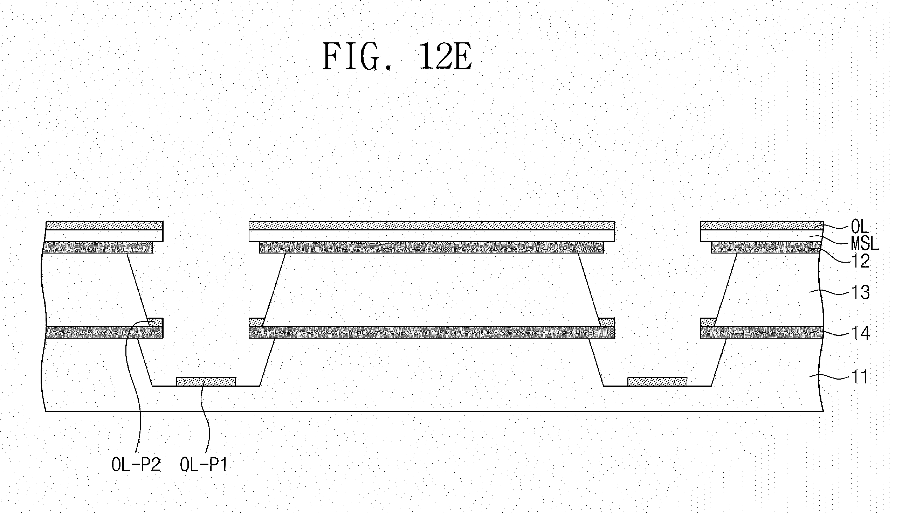

Then, as shown in FIG. 12E, the organic layer OL is formed. The organic layer OL may be formed by an evaporation process. Accordingly, the organic layer OL may be formed on the front surface of the first barrier layer 12 and within the blocking groove BR. For example, the first portion OL-P1 may be formed on the first base layer 11 within the blocking groove BR, and the second portion OL-P2 may be formed on the second barrier layer 14 within the blocking groove BR.

In the present disclosure, the organic layer OL is formed in a thickness direction. Accordingly, the organic layer OL may be difficult to be formed in a space having an undercut shape. Thus, the organic layer OL may be cut off by the blocking groove BR.

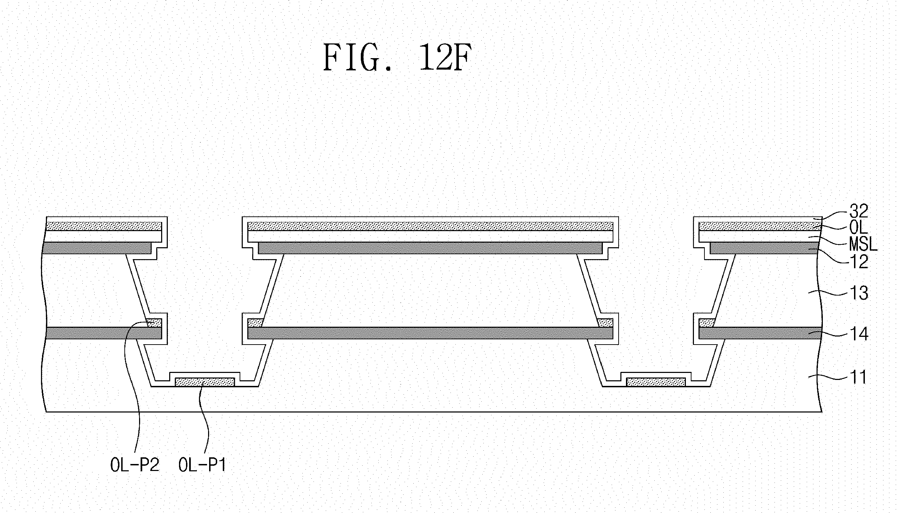

Then, as shown in FIG. 12F, the first inorganic film 32 is formed. The first inorganic film 32 may be formed on the front surface of the base substrate. In an embodiment, the first inorganic film 32 may be formed by an evaporation process. Accordingly, the first inorganic film 32 may be stably formed in an area having an undercut shape as well. The first inorganic film 32 covers an area including the blocking groove BR and a periphery area of the blocking groove BR.

In an embodiment, the portions OL-P1, OL-P2 of the organic layer that are formed in the blocking groove BR may be covered by the first inorganic film 32. The portions OL-P1, OL-P2 of the organic layer may be captured in the blocking groove BR by the first inorganic film 32. Accordingly, the problem that the portions OL-P1, OL-P2 of the organic layer are moved from the blocking groove BR or floated in a subsequent process step, thereby damaging other devices may be prevented or substantially prevented.

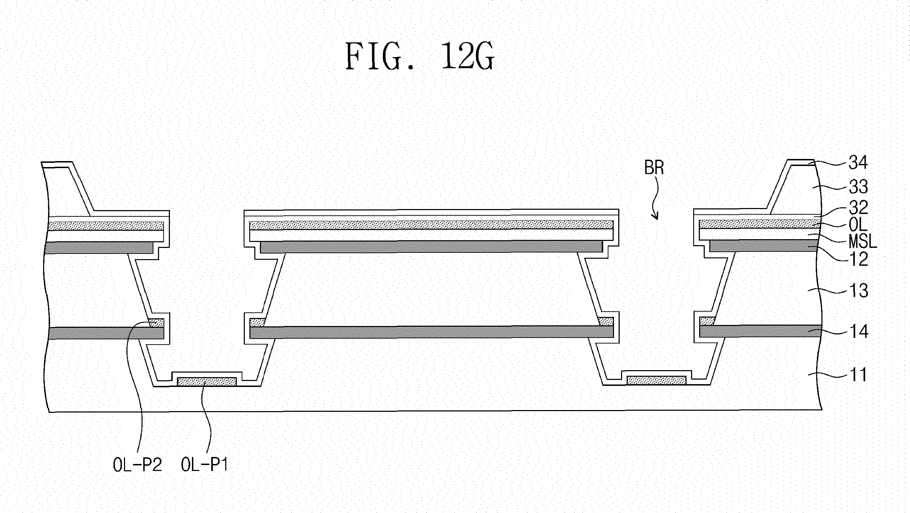

Then, as shown in FIG. 12G, the organic film 33 and the second inorganic film 34 are formed. In an embodiment, the organic film 33 may be formed through an inkjet process. A liquid organic material is provided in an area of the display area DA (see FIG. 4) that is spaced from the blocking groove BR, and may be coated on at least a portion of the first inorganic film 32 based on viscosity of the organic material, etc. As shown in FIG. 12G, the organic film 33 may be formed not to overlap the blocking groove BR.

Then, the second inorganic film 34 is formed. In an embodiment, the second inorganic film 34 may be formed through a deposition process. Accordingly, the second inorganic film 34 may be formed on the front surface of the organic film 33 and the first inorganic film 32.

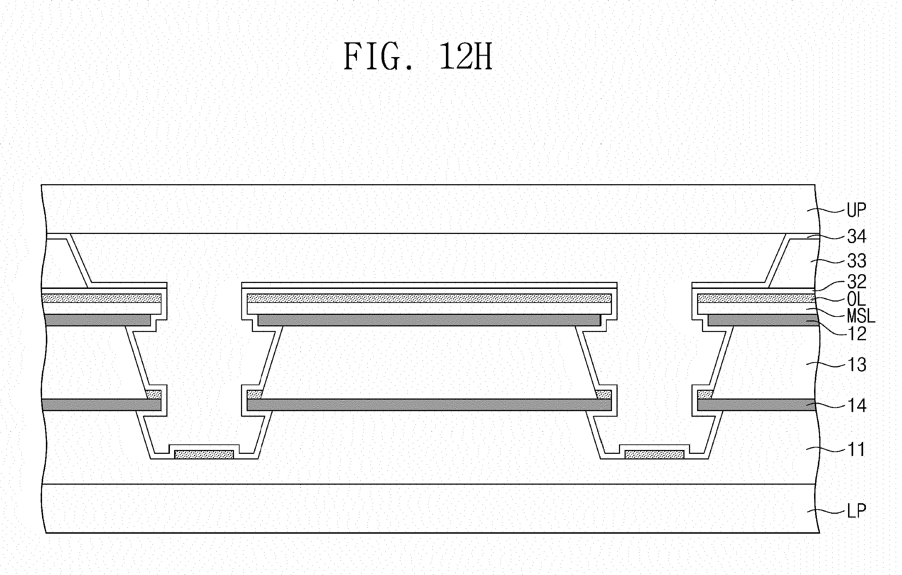

Then, as shown in FIG. 12H, the upper film UP and the lower film LP may be attached. The lower film LP may be attached to the rear surface of the first base layer 11. In an embodiment, an adhesive member (not shown) may be provided between the lower film LP and the first base layer 11. The upper film UP may be disposed on the second inorganic film 34. In an embodiment, an adhesive member (not shown) may be provided between the upper film UP and the first base layer 11.

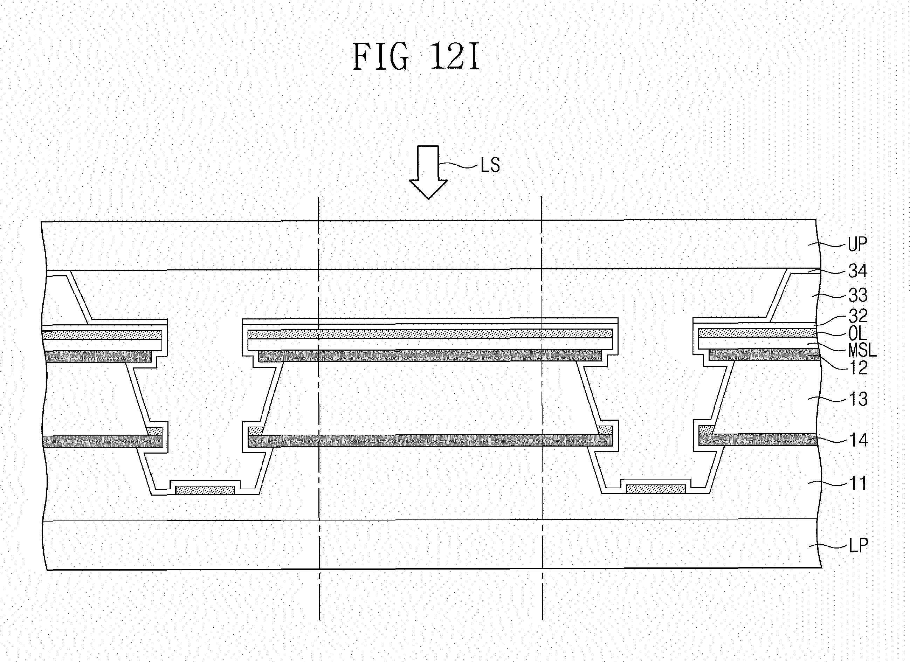

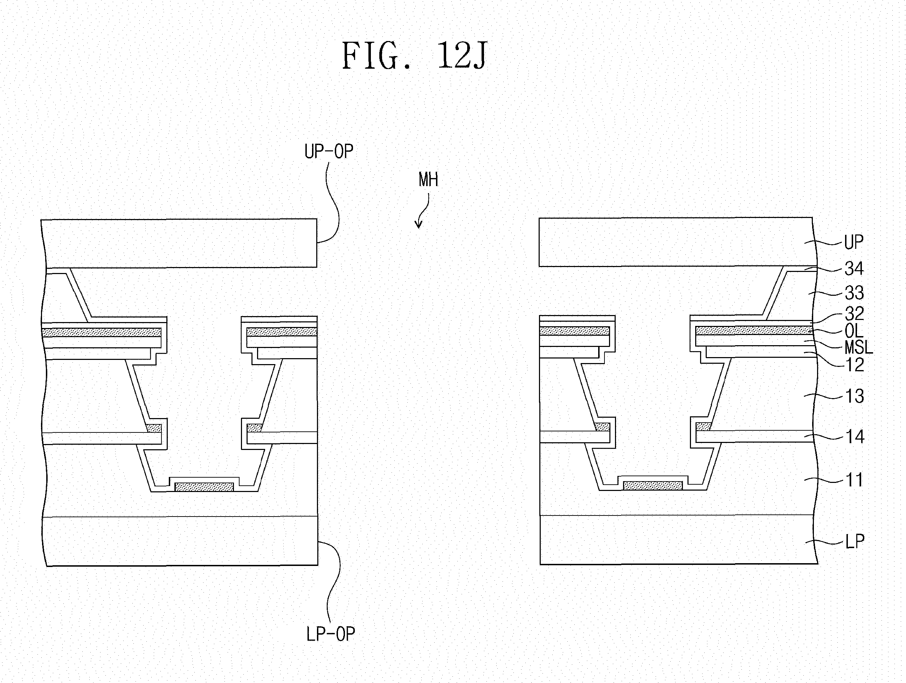

Then, as shown in FIGS. 12I and 12J, the module hole MH is formed by removing a portion of the display panel. The module hole MH may be formed in an area surrounded by the blocking groove BR. As shown in FIG. 12I, light LS is irradiated in an area delimited by dashed dotted lines. The light LS may include a laser of a short wavelength. Accordingly, the module hole MH may include a passing-through portion LP-OP passing through the lower film LP and a passing-through portion UP-OP passing through the upper film UP.

The module hole MH is formed through a cutting process using the light LS. Accordingly, the light may have a wavelength band different from the light LS in forming the blocking groove BR. However, the module hole MH may be formed by using a knife, a drill, etc., and is not limited to any embodiment.

As the module hole MH is formed, cross sections of the first base layer 11, the first barrier layer 12, the second base layer 13, the second barrier layer 14, the cover layer MSL, the organic film OL, the first inorganic film 32, and the second inorganic film 34 may be exposed to the outside. Here, the cross sections exposed to the outside may become an inflow path by which external moisture or oxygen may be introduced through the layers. Particularly, the organic layer OL containing an organic material is relatively easier for moisture/oxygen to penetrate.

The display panel according to an embodiment of the inventive concept includes the blocking groove BR formed adjacent to the module hole MH. The blocking groove BR cuts off or separates continuity of layers having a cross section exposed by the module hole MH, such as the organic layer OL, the first barrier layer 12, the second barrier layer 14, and the second base layer 13. Particularly, in the case of the organic layer OL, the portion exposed by the module hole MH is cut off or separated from the portion disposed under the thin film sealing layer. Accordingly, a problem of devices in the display area being damaged by external moisture or oxygen introduced through the module hole MH may be prevented or substantially prevented. Thus, reliability of the display panel according to an embodiment of the inventive concept may be improved.

According to the present disclosure, it is possible to easily prevent or substantially prevent damage to devices by moisture or oxygen introduced from the outside. Thus, an electronic device with improved reliability in process and in use may be provided. Further, according to the present disclosure, a blocking groove with reduced defects may be easily designed without adding a separate process. Thus, a process is simplified, and process cost may be reduced.

## Claims

1. A display panel (100) comprising:
a base substrate (10) comprising a front surface and a rear surface, and including a display area (DA) and a periphery area (NDA) adjacent to the display area (DA) in a plan view;
a pixel layer comprising a plurality of pixels, wherein each of the plurality of pixels comprises a thin film transistor (TR) and the plurality of pixels are in the display area (DA); and
a cover layer (MSL) on the base substrate (10) and containing an inorganic material and covering the front surface of the base substrate (10),
wherein
the base substrate (10) comprises:
a module hole (MH) defined in the display area (DA) and passing through the front surface and the rear surface of the base substrate (10); and
wherein the display panel (100) further comprises a blocking groove (BR) defined in the display area (DA) and adjacent to the module hole (MH), wherein the blocking groove (BR) has a shape of a closed curve surrounding the module hole (MH) when viewed in a plane; and
wherein the transistors (TR) are disposed on the front surface of the base substrate (10),
**characterized in that** the blocking groove (BR) is recessed from the front surface of the base substrate (10), and the cover layer comprises a passing-through portion (MSL-OP) overlapping the blocking groove (BR).

2. The display panel (100) according to claim 1, wherein
the base substrate (10) comprises:
a first base layer (11) containing an organic material and comprising the rear surface of the base substrate (10); and
a first barrier layer (12) containing an inorganic material and arranged on the first base layer (11) to define the front surface of the base substrate (10), and wherein
the blocking groove (BR) comprises:
a passing-through portion passing through the first barrier layer (12); and
a recessed portion defined in the first base layer (11) by overlapping the passing-through portion passing through the first barrier layer (12), and wherein
a width of the passing-through portion of the cover layer is equal to or less than a width of the passing-through portion passing through the first barrier layer (12).

3. The display panel (100) according to claim 2, wherein a width of the recessed portion is greater than the width of the passing-through portion passing through the first barrier layer (12).

4. The display panel (100) according to claim 2 or 3, wherein
the base substrate (10) further comprises:
a second base layer (13) between the first base layer (11) and the first barrier layer (12) and containing an organic material; and
a second barrier layer (14) between the first base layer (11) and the first barrier layer (12) and containing an inorganic material, and wherein
the first barrier layer (12) and the second barrier layer (14) are alternately arranged with the second base layer (13) and the first base layer (11) .

5. The display panel (100) according to claim 4, wherein
the blocking groove (BR) further comprises:
a passing-through portion passing through the second barrier layer (14); and
a passing-through portion passing through the second base layer (13), and wherein
a width of the passing-through portion passing through the second barrier layer (14) is less than a width of the passing-through portion passing through the second base layer (13).

6. The display panel (100) according to claim 4, wherein the first barrier layer (12) protrudes from the second base layer (13) within the blocking groove (BR), and the second barrier layer (14) protrudes from the first barrier layer (12) within the blocking groove (BR)

7. The display panel (100) according to any of claims 1 to 6, wherein
the pixel layer comprises:
a thin film device layer (20) on the base substrate (10) and comprising each of the plurality of thin film transistors; and
a display device layer (30) on the base substrate (10) and comprising a plurality of organic light emitting devices connected to the thin film transistors and wherein
the cover layer comprises a portion of the display device layer (30) and the thin film device layer (20).

8. The display panel (100) according to claim 7, wherein the cover layer comprises an inorganic film or a metal film.

9. The display panel (100) according to claim 7 or 8, wherein each of the plurality of organic light emitting devices comprises:
a first electrode (E1);
an organic layer on the first electrode (E1) and comprising an organic light emitting layer; and
a second electrode (E2) on the organic layer, and wherein
the thin film device layer (20) comprises a plurality of conductive layers and a plurality of insulation layers, and
the cover layer extends from at least one of the conductive layers, the insulation layers, and the first electrode (E1).

10. The display panel (100) according to claim 9, wherein the display device layer (30) further comprises a sealing member (TE) on the organic light emitting layer, wherein the sealing member (TE) covers the blocking groove (BR) and the passing-through portion of the cover layer.

11. The display panel (100) according to claim 10, wherein
the sealing member (TE) comprises: a first inorganic film (32); a second inorganic film (34) on the first inorganic film (32); and an organic film (33) between the first inorganic film (32) and the second inorganic film (34), wherein
the first inorganic film (32) and the second inorganic film (34) on the organic light emitting device are spaced from each other with the organic film (33) therebetween, and are in contact with each other within the blocking groove (BR).

12. An electronic device comprising:
a display panel (100) according to any of claims 1 to 11,
an electronic module electrically connected to the display panel (100),
wherein the electronic module overlaps the module hole (MH) of the display panel (100) in a plan view.

13. The electronic device according to claim 12, wherein the electronic module comprises at least one of a voice output module, an image capturing module, and a light receiving module.

## Patentansprüche

1. Anzeigepanel (100), umfassend:
ein Basissubstrat (10), das eine vordere Oberfläche und eine hintere Oberfläche umfasst und einen Anzeigebereich (DA) und einen Randbereich (NDA), der dem Anzeigebereich (DA) in einer Draufsicht benachbart ist, umfasst;
eine Pixelschicht, die eine Mehrzahl von Pixeln umfasst, wobei jedes der Mehrzahl von Pixeln einen Dünnfilmtransistor (TR) umfasst und die Mehrzahl von Pixeln sich in dem Anzeigebereich (DA) befindet; und
eine Deckschicht (MSL) auf dem Basissubstrat (10) und ein anorganisches Material enthaltend und die vordere Oberfläche des Basissubstrates (10) abdeckend,
wobei
das Basissubstrat (10) Folgendes umfasst:
ein Modulloch (MH), das in dem Anzeigebereich (DA) definiert ist und durch die vordere Oberfläche und die hintere Oberfläche des Basissubstrates (10) verläuft; und
wobei das Anzeigepanel (100) ferner eine Sperrnut (BR) umfasst, die in dem Anzeigebereich (DA) definiert und dem Modulloch (MH) benachbart ist, wobei die Sperrnut (BR), in einer Ebene gesehen, eine Form einer geschlossenen Kurve aufweist, die das Modulloch (MH) umgibt;
wobei die Transistoren (TR) auf der vorderen Oberfläche des Basissubstrates (10) angeordnet sind,
**dadurch gekennzeichnet, dass** die Sperrnut (BR) von der vorderem Oberfläche des Basissubstrates (10) aus vertieft ist und die Deckschicht einen Durchgangsabschnitt (MSL-OP) umfasst, der die Sperrnut (BR) überlappt.

2. Anzeigepanel (100) nach Anspruch 1, wobei
das Basissubstrat (10) Folgendes umfasst:
eine erste Basisschicht (11), die ein organisches Material enthält und die hintere Oberfläche des Basissubstrates (10) umfasst; und
eine erste Barriereschicht (12), die ein anorganisches Material enthält und auf der ersten Basisschicht (11) angeordnet ist, um die vordere Oberfläche des Basissubstrates (10) zu definieren, und wobei
die Sperrnut (BR) Folgendes umfasst:
einen Durchgangsabschnitt, der durch die erste Barriereschicht (12) verläuft; und
einen vertieften Abschnitt, der in der ersten Basisschicht (11) durch Überlappen des Durchgangsabschnittes, der durch die erste Barriereschicht (12) verläuft, definiert ist, und wobei
eine Breite des Durchgangsabschnittes der Deckschicht gleich einer oder schmaler als eine Breite des Durchgangsabschnittes, der durch die erste Barriereschicht (12) verläuft, ist.

3. Anzeigepanel (100) nach Anspruch 2, wobei eine Breite des vertieften Abschnittes breiter ist als die Breite des Durchgangsabschnittes, der durch die erste Barriereschicht (12) verläuft.

4. Anzeigepanel (100) nach Anspruch 2 oder 3, wobei
das Basissubstrat (10) ferner Folgendes umfasst:
eine zweite Basisschicht (13) zwischen der ersten Basisschicht (11) und der ersten Barriereschicht (12) und ein organisches Material enthaltend; und
eine zweite Barriereschicht (14) zwischen der ersten Basisschicht (11) und der ersten Barriereschicht (12) und ein anorganisches Material enthaltend, und wobei
die erste Barriereschicht (12) und die zweite Barriereschicht (14) abwechselnd mit der zweiten Basisschicht (13) und der ersten Basisschicht (11) angeordnet sind.

5. Anzeigepanel (100) nach Anspruch 4, wobei
die Sperrnut (BR) ferner Folgendes umfasst:
einen Durchgangsabschnitt, der durch die zweite Barriereschicht (14) verläuft; und
einen Durchgangsabschnitt, der durch die zweite Basisschicht (13) verläuft, und wobei
eine Breite des Durchgangsabschnittes, der durch die zweite Barriereschicht (14) verläuft, schmaler ist als eine Breite des Durchgangsabschnittes, der durch die zweite Basisschicht (13) verläuft.

6. Anzeigepanel (100) nach Anspruch 4, wobei innerhalb der Sperrnut (BR) die erste Barriereschicht (12) von der zweiten Basisschicht (13) hervorragt und innerhalb der Sperrnut (BR) die zweite Barriereschicht (14) von der ersten Barriereschicht (12) hervorragt.

7. Anzeigepanel (100) nach einem der Ansprüche 1 bis 6, wobei die Pixelschicht Folgendes umfasst:
eine Dünnfilmvorrichtungsschicht (20) auf dem Basissubstrat (10) und jeden der Mehrzahl von Dünnfilmtransistoren umfassend; und
eine Anzeigevorrichtungsschicht (30) auf dem Basissubstrat (10) und eine Mehrzahl von organischen lichtemittierenden Vorrichtungen, die mit den Dünnfilmtransistoren verbunden sind, umfassend, und wobei
die Deckschicht einen Abschnitt der Anzeigevorrichtungsschicht (30) und die Dünnfilmvorrichtungsschicht (20) umfasst.

8. Anzeigepanel (100) nach Anspruch 7, wobei die Deckschicht einen anorganischen Film oder einen Metallfilm umfasst.

9. Anzeigepanel (100) nach Anspruch 7 oder 8, wobei
jede der Mehrzahl von organischen lichtemittierenden Vorrichtungen Folgendes umfasst:
eine erste Elektrode (E1);
eine organische Schicht auf der ersten Elektrode (E1) und eine organische lichtemittierende Schicht umfassend; und
eine zweite Elektrode (E2) auf der organischen Schicht, und wobei
die Dünnfilmvorrichtungsschicht (20) eine Mehrzahl von leitfähigen Schichten und eine Mehrzahl von Isolierungsschichten umfasst und
die Deckschicht sich von mindestens einer aus den leitfähigen Schichten, den Isolierungsschichten und der ersten Elektrode (E1) aus erstreckt.

10. Anzeigepanel (100) nach Anspruch 9, wobei die Anzeigevorrichtungsschicht (30) ferner ein Dichtungselement (TE) auf der organischen lichtemittierenden Schicht umfasst, wobei das Dichtungselement (TE) die Sperrnut (BR) und den Durchgangsabschnitt der Deckschicht bedeckt.

11. Anzeigepanel (100) nach Anspruch 10, wobei
das Dichtungselement (TE) Folgendes umfasst: einen ersten anorganischen Film (32); einen zweiten anorganischen Film (34) auf dem ersten anorganischen Film (32); und einen organischen Film (33) zwischen dem ersten anorganischen Film (32) und dem zweiten anorganischen Film (34), wobei
der erste anorganische Film (32) und der zweite anorganische Film (34) auf der organischen lichtemittierenden Vorrichtung voneinander mit dem organischen Film (33) dazwischen beabstandet sind und innerhalb der Sperrnut (BR) miteinander in Kontakt stehen.

12. Elektronische Vorrichtung, umfassend:
ein Anzeigepanel (100) nach einem der Ansprüche 1 bis 11,
ein elektronisches Modul, das elektrisch mit dem Anzeigepanel (100) verbunden ist,
wobei das elektronische Modul das Modulloch (MH) des Anzeigepanels (100) in einer Draufsicht überlappt.

13. Elektronische Vorrichtung nach Anspruch 12, wobei das elektronische Modul mindestens eines aus einem Sprachausgabemodul, einem Bilderfassungsmodul und einem Lichtempfangsmodul umfasst.

## Revendications

1. Panneau d'affichage (100) comprenant :
un substrat de base (10) comprenant une surface avant et une surface arrière, et incluant une zone d'affichage (DA) et une zone de périphérie (NDA) adjacente à la zone d'affichage (DA) dans une vue de dessus ;
une couche de pixels comprenant une pluralité de pixels, dans lequel chacun de la pluralité de pixels comprend un transistor à film mince (TR) et la pluralité de pixels sont dans la zone d'affichage (DA) ; et
une couche de recouvrement (MSL) sur le substrat de base (10) et contenant un matériau inorganique et recouvrant la surface avant du substrat de base (10),
dans lequel
le substrat de base (10) comprend :
un trou de module (MH) défini dans la zone d'affichage (DA) et traversant la surface avant et la surface arrière du substrat de base (10) ; et
dans lequel le panneau d'affichage (100) comprend en outre une rainure de blocage (BR) définie dans la zone d'affichage (DA) et adjacente au trou de module (MH), dans lequel la rainure de blocage (BR) a la forme d'une courbe fermée entourant le trou de module (MH) lorsqu'elle est observée dans un plan ; et
dans lequel les transistors (TR) sont disposés sur la surface avant du substrat de base (10),
**caractérisé en ce que** la rainure de blocage (BR) est en retrait à partir de la surface avant du substrat de base (10), et la couche de recouvrement comprend une portion traversante (MSL-OP) chevauchant la rainure de blocage (BR) .

2. Panneau d'affichage (100) selon la revendication 1, dans lequel
le substrat de base (10) comprend :
une première couche de base (11) contenant un matériau organique et comprenant la surface arrière du substrat de base (10) ; et
une première couche barrière (12) contenant un matériau inorganique et agencée sur la première couche de base (11) pour définir la surface avant du substrat de base (10), et dans lequel
la rainure de blocage (BR) comprend :
une portion traversante traversant la première couche barrière (12) ; et
une portion en retrait définie dans la première couche de base (11) en chevauchant la portion traversante traversant la première couche barrière (12), et dans lequel
une largeur de la portion traversante de la couche de recouvrement est égale ou inférieure à une largeur de la portion traversante traversant la première couche barrière (12) .

3. Panneau d'affichage (100) selon la revendication 2, dans lequel une largeur de la portion en retrait est supérieure à la largeur de la portion traversante traversant la première couche barrière (12).

4. Panneau d'affichage (100) selon la revendication 2 ou 3, dans lequel
le substrat de base (10) comprend en outre :
une seconde couche de base (13) entre la première couche de base (11) et la première couche barrière (12) et contenant un matériau organique ; et
une seconde couche barrière (14) entre la première couche de base (11) et la première couche barrière (12) et contenant un matériau inorganique, et dans lequel
la première couche barrière (12) et la seconde couche barrière (14) sont agencées en alternance avec la seconde couche de base (13) et la première couche de base (11).

5. Panneau d'affichage (100) selon la revendication 4, dans lequel
la rainure de blocage (BR) comprend en outre :
une portion traversante traversant la seconde couche barrière (14) ; et
une portion traversante traversant la seconde couche de base (13), et dans lequel
une largeur de la portion traversante traversant la seconde couche barrière (14) est inférieure à une largeur de la portion traversante traversant la seconde couche de base (13).

6. Panneau d'affichage (100) selon la revendication 4, dans lequel la première couche barrière (12) fait saillie de la seconde couche de base (13) au sein de la rainure de blocage (BR), et la seconde couche barrière (14) fait saillie de la première couche barrière (12) au sein de la rainure de blocage (BR).

7. Panneau d'affichage (100) selon l'une quelconque des revendications 1 à 6, dans lequel la couche de pixels comprend :
une couche de dispositif à film mince (20) sur le substrat de base (10) et comprenant chacun de la pluralité de transistors à film mince ; et
une couche de dispositif d'affichage (30) sur le substrat de base (10) et comprenant une pluralité de dispositifs électroluminescents organiques connectés aux transistors à film mince, et dans lequel la couche de recouvrement comprend une portion de la couche de dispositif d'affichage (30) et de la couche de dispositif à film mince (20).

8. Panneau d'affichage (100) selon la revendication 7, dans lequel la couche de recouvrement comprend un film inorganique ou un film en métal.

9. Panneau d'affichage (100) selon la revendication 7 ou 8, dans lequel chacun de la pluralité de dispositifs électroluminescents organiques comprend :
une première électrode (E1) ;
une couche organique sur la première électrode (E1) et comprenant une couche électroluminescente organique ; et
une seconde électrode (E2) sur la couche organique, et
dans lequel
la couche de dispositif à film mince (20) comprend une pluralité de couches conductrices et une pluralité de couches d'isolation, et
la couche de recouvrement s'étend à partir d'au moins une des couches conductrices, des couches d'isolation, et de la première électrode (E1).

10. Panneau d'affichage (100) selon la revendication 9, dans lequel la couche de dispositif d'affichage (30) comprend en outre un élément de scellement (TE) sur la couche électroluminescente organique, dans lequel l'élément de scellement (TE) recouvre la rainure de blocage (BR) et la portion traversante de la couche de recouvrement.

11. Panneau d'affichage (100) selon la revendication 10, dans lequel
l'élément de scellement (TE) comprend : un premier film inorganique (32) ; un second film inorganique (34) sur le premier film inorganique (32) ; et un film organique (33) entre le premier film inorganique (32) et le second film inorganique (34), dans lequel
le premier film inorganique (32) et le second film inorganique (34) sur le dispositif électroluminescent organique sont espacés l'un de l'autre avec le film organique (33) entre ceux-ci, et sont en contact l'un avec l'autre au sein de la rainure de blocage (BR).

12. Dispositif électronique comprenant :
un panneau d'affichage (100) selon l'une quelconque des revendications 1 à 11,
un module électronique connecté électriquement au panneau d'affichage (100),
dans lequel le module électronique chevauche le trou de module (MH) du panneau d'affichage (100) dans une vue de dessus.

13. Dispositif électronique selon la revendication 12, dans lequel le module électronique comprend au moins un d'un module de sortie vocale, d'un module de capture d'images, et d'un module de réception de lumière.
